# EUROPEAN PATENT APPLICATION

(11) **EP 1 344 841 A1**
(43) Date of publication of application: **17.09.2003**
(21) Application number: 03251429.1
(22) Date of filing: 10.03.2003
(51) Int. Cl.: C23C 16/02, C23C 16/27

(54) **Base material for forming diamond film**

(30) Priority: 11.03.2002 JP 2002064706
(71) Applicant: SHIN-ETSU CHEMICAL CO., LTD., Chiyoda-ku Tokyo (JP)
(72) Inventor: Noguchi, Hitoshi, Adv. Funct. Mat. Res. Centre, Annaka-shi, Gunma-ken (JP)
(74) Representative: Cooper, John

(57) **Abstract**

There is disclosed a base material for forming a diamond film by vapor phase synthesis, wherein diamond particles having a particle (13) diameter of 2 nm to 100 nm exist at a density of 1 x 10⁸ to 1 x 10¹³ number/cm² on a surface of the base material (11), and spaces among the diamond particles are filled with diamond particles having a particle diameter of less than 2 nm. There can be provided a base material for forming a diamond film (14) by vapor phase synthesis which can provide a high generation density of diamond nuclei and a continuous diamond film even with an extremely small film thickness such as 10 µm or less.

## Description

### BACKGROUND OF THE INVENTION

### Field of the Invention

The present invention relates to a base material for forming a diamond film by vapor phase synthesis and a diamond film.

### Related Art

In recent years, diamond films formed on base materials by utilizing unique properties of diamond have been widely investigated. For example, they are investigated as masking members for exposure in lithography techniques used in the semiconductor device production, substrates for surface acoustic wave (SAW) devices, grinding and polishing tools and so forth.

Diamond is excellent in, for example, Young's modulus, etching resistance, high-energy ray irradiation resistance and so forth, and use thereof as a masking membrane in the X-ray lithography and electron beam lithography attracts attentions, which enables formation of extremely fine patterns of 100 nm or less.

As the methods for producing diamond films, there are known vapor phase synthesis methods, i.e., methods of using DC arc discharge, DC glow discharge, combustion flame, radiofrequency wave (R.F.), microwave, hot filament and so forth. Among these production methods, the microwave CVD method and the hot filament CVD method are generally used, since they enable formation of films having a large size and good crystallinity.

Meanwhile, silicon is used as a masking substrate for the X-ray or electron beam lithography, since it is advantageous for the semiconductor production processes. However, even if a diamond film is formed on such a substrate by the aforementioned methods as they are, nuclei of diamond are hardly generated, and thus a diamond film hardly grows. Therefore, it has been proposed to subject the substrate before the film formation to a treatment as described below (referred to as "pretreatment") to enhance the generation of the nuclei.

That is, as the methods of the pretreatment, there have been proposed the conventional scratch method in which a base material surface is polished with paste containing diamond particles and the ultrasonic scratch method in which the treatment is performed by immersing a base material in a fluid dispersion obtained by dispersing diamond particles in acetone, ethanol or the like. It is considered that scratches or certain particles formed on the base material surface by these scratch pretreatment methods contribute to the generation of nuclei for growth of diamond.

Moreover, a method of enhancing the generation of nuclei by applying a bias voltage to a base material before and during the film formation has also been proposed as the pretreatment method. Furthermore, a method of forming a silicon carbide layer on a silicon substrate surface to obtain an effect that the formation of nuclei for growth of diamond becomes easy has also been proposed.

Among them, it is the scratch method that attracts attentions from the viewpoint of practical use, and many manufacturers actually employ that method.

However, although the pretreatment by the various kinds of methods mentioned above is effective to a certain degree, when it is attempted to grow diamond films on base materials for forming a diamond film subjected to a pretreatment according to such methods as described above, the growth of film may sometimes become difficult.

Therefore, as a novel method for uniformly generating diamond nuclei at a high density on a base material having a large area, e.g., a diameter of 3 inches or more required in the industrial fields, the inventor of the present invention previously proposed the so-called fluidized bed pretreatment method which is performed by introducing a base material into a bed fluidized with a gaseous fluid at a velocity higher than the velocity for initiating fluidization of diamond particles (Japanese Patent Publication Laid-open (Kokai) No. 9-260251).

However, surface conditions of a base material for forming a diamond film that can surely provide a continuous film even with an extremely small film thickness such as 10 µm or less as required recently, that is, particle diameter of diamond particles adhering to the base material surface, adhesion density of diamond particles, thickness of the adhered diamond particle layer and so forth have not been elucidated.

Therefore, quantitative definitions of surface conditions of a base material for forming a diamond film that can surely provide a continuous film even with an extremely small film thickness of 10 µm or less required for masking materials for use in X-ray or electron beam lithography have been required by all means.

### SUMMARY OF THE INVENTION

The present invention was accomplished in view of the aforementioned problems, and its object is to provide a base material for forming a diamond film by vapor phase synthesis which can provide a high generation density of diamond nuclei and a continuous diamond film even with an extremely small film thickness such as 10 µm or less.

The present invention was accomplished in order to achieve the aforementioned object, and provides a base material for forming a diamond film by vapor phase synthesis, wherein at least a layer of diamond particles having a particle diameter of 2 nm to 100 nm is adhered to a base material surface.

If diamond particles having a large diameter of 2 nm to 100 nm are adhered on the base material as described above, the adhered diamond serves as nuclei and thus it becomes possible to easily form diamond in the diamond film formation by vapor phase synthesis.

In this case, the diamond particles having the aforementioned particle diameter and adhering to the base material surface preferably exist at a density of 1 x 10⁸ to 1 x 10¹³ number/cm².

If the diamond particles of the aforementioned particle diameter adhere to the base material surface at such a density, a continuous film of polycrystal diamond having high crystallinity can surely be obtained by the vapor phase synthesis method even with a small film thickness of 10 µm or less.

Furthermore, if spaces among the diamond particles having the aforementioned particle diameter and adhering to the base material surface are filled with diamond particles having a particle diameter of less than 2 nm, the adhesion strength of the diamond particles having a large diameter of 2 nm to 100 nm to the base material is increased, and removal of the diamond particles having a particle diameter of 2 nm to 100 nm from the base material surface can be reduced even in base material cleaning performed after the pretreatment and before the film formation by vapor phase synthesis.

Moreover, flatness of the outermost surface of the base material including the adhered particles is also improved. Therefore, a diamond film having few defects such as abnormal projections and pinholes on the surface of the diamond film after the film formation can be obtained.

As for the thickness of the diamond particle layer adhering to the base material surface according to the present invention, favorable results were obtained with a thickness of 2 nm to 100 nm.

Further, by treating a base material in a bed fluidized by a gaseous fluid having a velocity higher than the fluidization initiating velocity of diamond particles with adjustment of the conditions therefor, a base material for forming a diamond film by vapor phase synthesis, which is adhered with a layer of diamond particles having the diameter defined in the present invention, can be obtained.

Furthermore, it is preferable to use a silicon substrate or a silicon substrate on which a silicon nitride film is formed as the base material for use as, for example, a masking substrate for X-ray or electron beam lithography, because it is advantageous for semiconductor production processes.

Moreover, if a diamond film obtained by forming the film on the base material for forming a diamond film by vapor phase synthesis according to the present invention is used as a mask for X-ray or electron beam lithography, highly precise patterns can be transferred with a high throughput because the film is a continuous film of high crystallinity and high uniformity even as a thin diamond film having a thickness of 10 µm or less.

As explained above, if a base material for forming a diamond film in which diamond particles having a particle diameter of 2 nm to 100 nm are adhered on the surface is used, generation density of diamond nuclei becomes high, and it becomes possible to obtain a continuous diamond film even with an extremely small film thickness of 10 µm or less.

Furthermore, if a diamond film obtained by film formation on the base material for forming a diamond film of the present invention is used, for example, as a mask for X-ray or electron beam lithography, highly precise patterns can be transferred with a high throughput because a continuous film of high crystallinity and high uniformity can be obtained even as a thin diamond film having a thickness of 10 µm or less.

### BRIEF EXPLANATION OF THE DRAWINGS

Fig. 1 is a schematic view of the base material for forming a diamond film of the present invention.
Fig. 2 is a schematic view of a diamond particle fluidization treatment apparatus.

### PREFERRED EMBODIMENTS OF THE INVENTION

Hereafter, embodiments of the present invention will be explained. However, the present invention is not limited by these explanations.

The inventor of the present invention conceived that, if there could be quantitatively defined the surface conditions of a base material for forming diamond film by vapor phase synthesis that can provide a continuous diamond film having high crystallinity and uniform film thickness even as an extremely small film thickness of 10 µm or less, a continuous diamond film having high crystallinity and uniform film thickness could be more surely obtained, and thus accomplished the present invention.

The base material for forming a diamond film by vapor phase synthesis of which surface conditions are defined according to the present invention has at least a layer of diamond particles having a diameter of 2 nm to 100 nm adhered to the base material surface. If diamond particles having a large diameter of 2 nm to 100 nm are adhered on the base material as described above, the adhered diamond having a large diameter serves as nuclei, and thus it becomes possible to easily form diamond in the diamond film formation by vapor phase synthesis.

Further, the diamond particles having a particle diameter of 2 nm to 10 nm and adhering to the base material surface preferably exist at a density of 1 x 10⁸ to 1 x 10¹³ number/cm². This is because, if the diamond particles having a particle diameter of 2 nm to 100 nm adhere to the base material surface at such a density, a continuous film of polycrystal diamond of high crystallinity can be obtained by the vapor phase synthesis method even with a small film thickness of 10 µm or less. Further, if the diamond particles adhering to the base material consist only of particles having a diameter of less than 2 nm, a continuous film cannot be obtained even if diamond film formation is performed by the vapor phase synthesis method, and the surface of the base material is exposed. Thus, diamond may be formed in such a degree that only a little diamond is deposited on a peripheral portion of the base material or only island-like deposition may be obtained. On the other hand, if the particle diameter of the diamond particles adhering to the base material surface becomes larger than a diameter of 100 nm, the thickness of the formed diamond film becomes uneven, and the desired continuous uniform diamond film having a thickness of 10 µm or less cannot be obtained.

Furthermore, in the present invention, spaces among the diamond particles having a diameter of 2 nm to 100 nm and adhering to the base material surface are preferably filled with diamond particles having a particle diameter of less than 2 nm. As a result, the adhesion strength (close contact) of the diamond particles having a particle diameter of 2 nm to 100nm to the base material is increased, and removal of the diamond particles having a particle diameter of 2 nm to 100 nm from the base material surface can be prevented even when the base material is cleaned after the pretreatment and before the film formation by vapor phase synthesis. Moreover, flatness of the outermost surface of the base material including the adhered particles is also improved. Therefore, a diamond film having few defects such as abnormal projections and pinholes on the surface of the diamond film after the film formation can be obtained. This characteristic is particularly important for synthesis of an extremely thin diamond film such as a film having a thickness of 10 µm or less.

In addition, when the thickness of a layer of diamond particles having a diameter of 2 nm to 100 nm in the state that spaces among them are filled with diamond particles having a diameter of less than 2 nm, i.e., the thickness of the diamond particle layer, was 2 nm to 100 nm, results favorable for, in particular, uniformly synthesizing a thin diamond film were obtained.

The inventor of the present invention precisely analyzed surface conditions of a base material for forming a diamond film by vapor phase synthesis, which was subjected to a pretreatment, by using a transmission electron microscope (TEM), scanning electron microscope (SEM), atomic force microscope (AFM) and X-ray diffraction (XRD). Furthermore, the inventor of the present invention precisely analyzed film characteristics of a diamond film obtained by formation of diamond film according to the vapor phase synthesis method by using Raman spectroscopy, XRD, SEM and ellipsomter. The base material for forming a diamond film by vapor phase synthesis of which surface conditions are defined by the present invention is accomplished as a result of various studies of the relationship of the base material for forming a diamond film before the film formation and a diamond film after the film formation based on the analysis results mentioned above.

As for a material of the base material, it is preferable to use a silicon substrate or a silicon substrate on which a silicon nitride film is formed as a material advantageous for semiconductor production processes for use as a masking substrate for X-ray or electron beam lithography.

The pretreatment of the base material can be performed by using the fluidized bed pretreatment method, which is performed by introducing the base material into a bed fluidized by a gaseous fluid having a velocity higher than the fluidization initiating velocity for diamond particles (refer to Japanese Patent Publication Laid-open No. 9-260251).

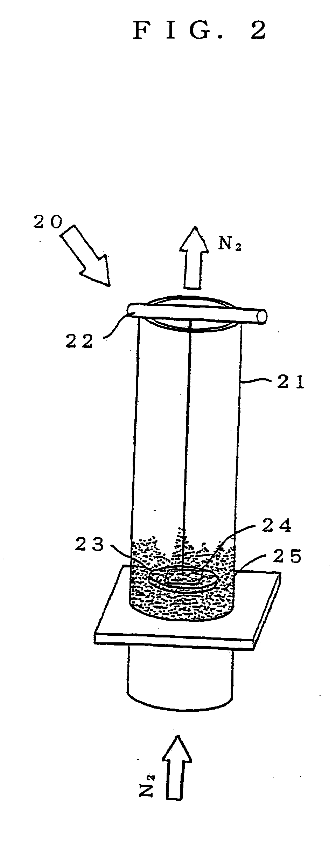

This method can be performed by using such a diamond particle fluidization treatment apparatus 20 as shown in Fig. 2. This fluidization treatment apparatus 20 comprises a treatment bed container 21 in which stainless steel mesh 23 fixed with a fixation jig 22 is disposed, and a base material 24 is disposed thereon. An inert carrier gas such as nitrogen is introduced from below through the stainless steel mesh 23 so that diamond particles 25 can be fluidized. The fluidized diamond particles 25 are brought into contact with a surface of the base material 24, and thereby the diamond particles are adhered to the surface of the base material 24 to obtain a base material for forming a diamond film by vapor phase synthesis. If the velocity of the gas for fluidizing diamond particles is less than five times the gas fluidization initiating velocity, sufficient fluidized bed may not be obtained, and on the other hand, if the velocity is set at a level exceeding 100 times the gas fluidization initiating velocity, fluidization layer may be disrupted. Therefore, the velocity of the gas for fluidizing diamond particles is desirably five times the gas fluidization initiating velocity or more, with an upper limit of 100 times the gas fluidization initiating velocity.

At that time, the particle diameter of the diamond used in the fluidized bed pretreatment is preferably 10 to 500 µm, and a particle diameter in this range enables the desired adhesion of diamond particles having a particle diameter of 2 nm to 100 nm on the base material surface. Further, the density of the diamond particles having a particle diameter of 2 nm to 100 nm adhering to the base material surface becomes 1 x 10⁸ to 1 x 10¹³ number/cm², and there can be obtained a state that spaces among the diamond particles having a particle diameter of 2 nm to 100 nm are filled with diamond particles having a particle diameter less than 2 nm.

A diamond film can be produced by the vapor phase synthesis method on a base material for forming a diamond film by vapor phase synthesis subjected to the pretreatment. The vapor phase synthesis method include, for example, methods utilizing DC arc discharge, DC glow discharge, combustion flame, radiofrequency wave (R.F.), microwave, hot filament and so forth. Among these methods, the microwave CVD method and the hot filament CVD method are preferred, since they enable formation of films having a large size and good crystallinity on a base material for forming a diamond film.

A diamond film obtained through film formation by, for example, the microwave CVD method or hot filament CVD method mentioned above on a base material for forming a diamond film of the present invention having a layer of diamond particles of a large particle diameter can be a highly uniform continuous film showing high crystallinity even as a thin diamond film having a thickness of 10 µm or less. If this film is used as, for example, a mask for X-ray or electron beam lithography, highly precise patterns can be transferred with a high throughput.

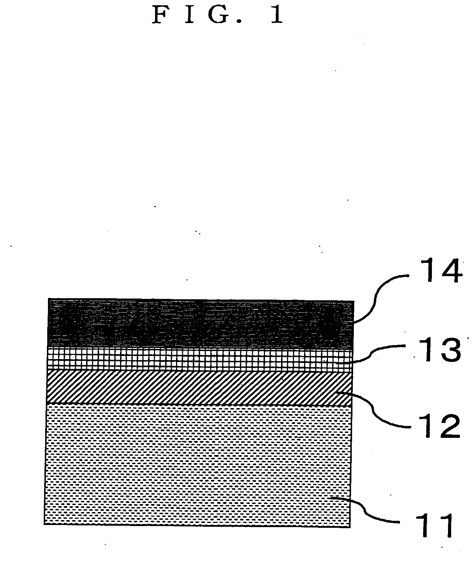

In the base material for forming a diamond film of the present invention as explained above, for example, a silicon nitride film 12 is formed on a silicon substrate 11, and a layer 13 of diamond particles having a particle diameter of 2 nm to 100 nm is formed thereon, as shown in Fig. 1. A diamond film 14 is formed on the layer 13 of diamond particles.

### EXAMPLES

Hereafter, the present invention will be explained more specifically with reference to an example and a comparative example. However, the present invention is not limited to these.

### (Example 1)

As a base material, used was a silicon wafer (crystalline plane orientation: (100)) having a diameter of 4 inches and a thickness of 625 µm, both of which surfaces were polished and then on which a silicon nitride film was formed with a thickness of 0.5 µm by the reduced pressure vapor phase synthesis method. The base material was subjected to a fluidized bed pretreatment with the surface on which a diamond film was to be formed facing downwardly. As a treatment vessel, a polyvinyl chloride resin tube having an inner diameter of 8 inches and a height of 1 meter was used.

As diamond particles, synthetic diamond particles having a particle diameter of 400 µm were placed into the vessel in an amount of 700 g, and nitrogen gas as a gaseous fluid was vertically and upwardly passed from below through a plate distributor. The base material was fixed approximately in the center of the fluidized bed of the diamond particles so that the surface to be treated should be perpendicular to the gas flow, and the treatment was performed for 3 hours.

In the above treatment, the velocity of the gas for fluidizing the diamond particles was set at a level of 30 times the gas fluidization initiating velocity so that the particle diameter in a diamond particle layer formed on the base material should become 2 nm to 80 nm.

The surface of the obtained base material for forming a diamond film was observed by using TEM, SEM, AFM etc. As a result, it was found that diamond particles having a diameter of 2 nm to 80 nm were present at a density of 3 x 10¹¹ number/cm². In addition, there was observed a structure that spaces among the diamond particles having such a large particle diameter were filled with diamond particles having a particle diameter of less than 2 nm. The layer of the adhered diamond had a thickness in the range of 7 nm to 85 nm.

After the base material for forming a diamond film was cleaned, a diamond film was formed on the base material by the microwave vapor phase synthesis method. First, the base material subjected to the pretreatment was set in a chamber, the chamber was evacuated to a base pressure of 10⁻³ Torr by a rotary pump, and then hydrogen and methane as the raw material gases were introduced at flow rates of 997 cc/min and 3 cc/min, respectively. The internal pressure of the chamber was made to 30 Torr by adjusting opening degree of a valve connected to an evacuation system, and then microwaves (2.45 GHz) of 3 kW power were applied to perform film formation for 10 hours. The obtained diamond film was a continuous film, and had a thickness of 0.9 µm, 1.0 µm and 1.2 µm at the positions of 10 mm, 30 mm and 50 mm from the periphery of the base material. This means a uniformity of ± 14% with respect to an average film thickness of 1.0 µm.

### (Comparative Example 1)

The same silicon wafer substrate on which a silicon nitride film was formed as that used in the example was used as a base material, and the pretreatment was performed by the conventional scratch method. That is, the base material of which surface was polished with paste containing diamond particles having a diameter of 5 µm for 30 minutes and cleaned with pure water was used as the base material.

The surface of the obtained base material for forming a diamond film was observed by using TEM, SEM, AFM etc. As a result, diamond particles having a large diameter of 2 nm to 100 nm were not confirmed, and there were only diamond particles having a particle diameter of less than 2 nm. The thickness of the adhered diamond layer was in the range of 2 nm to 33 nm.

Then, a diamond film was formed under the same conditions as those used for the example. However, a continuous film could not be obtained, and the silicon nitride film of the base material was exposed. And only a little diamond was deposited on peripheral portions of the base material.

The present invention is not limited to the embodiments described above. The above-described embodiments are mere examples, and those having the substantially same configurations as that described in the appended claims and providing the similar functions and advantages are all included in the scope of the present invention.

For example, applications of the base material for forming a diamond film and the diamond film of the present invention are not limited to the aforementioned masking members for X-ray or electron beam lithography.

## Claims

1. A base material for forming a diamond film by vapor phase synthesis, wherein at least a layer of diamond particles having a particle diameter of 2 nm to 100 nm is adhered to a base material surface.

2. The base material for forming a diamond film by vapor phase synthesis according to Claim 1, wherein the diamond particles having the particle diameter and adhering to the base material surface exist at a density of 1 x 10⁸ to 1 x 10¹³ number/cm².

3. The base material for forming a diamond film by vapor phase synthesis according to Claim 1 or 2, wherein spaces among the diamond particles having the particle diameter and adhering to the base material surface are filled with diamond particles having a particle diameter of less than 2 nm.

4. The base material for forming a diamond film by vapor phase synthesis according to any one of Claims 1 to 3, wherein the layer of the diamond particles adhering to the base material surface has a thickness of 2 nm to 100 nm.

5. The base material for forming a diamond film by vapor phase synthesis according to any one of Claims 1 to 4, wherein the diamond particles are adhered to the base material surface by a treatment in a fluidized bed of diamond particles.

6. The base material for forming a diamond film by vapor phase synthesis according to any one of Claims 1 to 5, wherein the base material to which the layer of diamond particles is adhered consists of a silicon substrate or a silicon substrate on which a silicon nitride film is formed.

7. A diamond film synthesized by using the base material for forming a diamond film by vapor phase synthesis according to any one of Claims 1 to 6.
